# EUROPEAN PATENT APPLICATION

(11) **EP 4 836 672 A1**
(43) Date of publication of application: **04.11.2026**
(21) Application number: 25207363.0
(22) Date of filing: 07.10.2025
(51) Int. Cl.: H10W 70/685, H10W 90/00, H10W 70/60, H10W 90/10

(54) **SEMICONDUCTOR PACKAGE AND METHOD FOR FORMING THE SAME**

(30) Priority: 30.04.2025 US 202519194394
(71) Applicant: MEDIATEK INC., Hsinchu City 30078 (TW)
(72) Inventor: CHI, Yen-Yao, 30078 Hsinchu City (TW); YU, Ta-Jen, 30078 Hsinchu City (TW); TSAI, Hung-Pin, 30078 Hsinchu City (TW); LU, Yu-Hsuan, 30078 Hsinchu City (TW); HO, Cheng-Wei, 30078 Hsinchu City (TW); LIN, Shih-Chin, 30078 Hsinchu City (TW)
(74) Representative: Haseltine Lake Kempner LLP

(57) **Abstract**

A semiconductor package and a method for forming the same are provided. The semiconductor package includes a redistribution layer (RDL) structure and a first die, a stress buffer structure and a conductive bump structure. The redistribution layer (RDL) structure has a first surface and a second surface opposite to the first surface. The first die is disposed on the first surface of the RDL structure. The stress buffer structure is disposed on the second surface of the RDL structure. The stress buffer structure includes a stress buffer layer and a conductive stud passing through the stress buffer layer. The conductive bump structure is disposed on the conductive stud and opposite to the first die, The conductive bump structure is electrically coupled to the first die by the stress buffer structure and the RDL structure.

## Description

### BACKGROUND OF THE DISCLOSURE

### Field of the Disclosure

The present disclosure relates to a semiconductor package and a method for forming the same. In particular, it relates to a stress buffer structure for a semiconductor package and a method for forming the same.

### Description of the Related Art

The continuous drive for higher computing power and higher data bandwidth to meet the growing demand from data centers, networking, and artificial intelligence has driven the development of advanced packaging solutions for higher performance devices.

Among the advanced packaging technologies, wafer-level fan-out has emerged as an attractive package solution for heterogeneous integration. Wafer-level fan-out, which uses fine-pitch redistribution layer (RDL) technology for die interconnection, can enable the development of high-performance products with a large package footprint, and high interconnect density. However, package reliability is becoming a critical concern as the overall die size and package size increase to accommodate the integration of more dies for networking and high-performance applications. As the die size increases, the package stress from the printed circuit board (PCB) will damage the dies. Also, the coefficient of thermal expansion (CTE) mismatch between the dies and the interposer increases the risk for package failures as well as RDL failures in the fan-out package.

Thus, a novel structure for a semiconductor package is desirable.

### BRIEF SUMMARY OF THE DISCLOSURE

An embodiment of the present disclosure provides a semiconductor package. The semiconductor package includes a redistribution layer (RDL) structure, a first die, a stress buffer structure and a conductive bump structure. The redistribution layer (RDL) structure has a first surface and a second surface. The first surface is opposite to the second surface. The first die is disposed on the first surface of the RDL structure. The stress buffer structure is disposed on the second surface of the RDL structure. The stress buffer structure includes a stress buffer layer and a conductive stud passing through the stress buffer layer. The conductive bump structure is disposed on the conductive stud and opposite to the first die. The conductive bump structure is electrically coupled to the first die by the stress buffer structure and the RDL structure.

An embodiment of the present disclosure provides a method for forming a semiconductor package. The method for forming a semiconductor package includes forming a conductive stud and a stress buffer layer surrounding the conductive stud on a carrier. The conductive stud and the stress buffer layer form a stress buffer structure. The method further includes forming a redistribution layer (RDL) structure on the stress buffer structure. The method further includes disposing a first die on the redistribution layer (RDL) structure. The method further includes forming a conductive bump structure on the conductive stud of the stress buffer structure and opposite to the first die.

### BRIEF DESCRIPTION OF THE DRAWINGS

The present disclosure can be more fully understood by reading the subsequent detailed description and examples with references made to the accompanying drawings, wherein:
FIG. 1 is a schematic cross-sectional view of a semiconductor package in accordance with some embodiments of the disclosure;
FIG. 2 is a schematic cross-sectional view of a semiconductor package in accordance with some embodiments of the disclosure;
FIGS. 3, 4, 5, 6, 7 and 8 are cross-sectional views of intermediate stages of forming the semiconductor package of FIG. 1 in accordance with some embodiments of the disclosure; and
FIGS. 9, 10, 11, 12, 13 and 14 are cross-sectional views of intermediate stages of forming the semiconductor package of FIG. 2 in accordance with some embodiments of the disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

In the conventional 2.5D (side-by-side) semiconductor package process, the redistribution layer (RDL) interposer is directly built on a carrier. No robust material is disposed between RDL layers of the RDL interposer and solder balls. When the semiconductor package is bonded to the printed circuit board (PCB), stress from PCB could not be effectively buffed by the RDL layers and damage the system-on-chip (SoC) die. In addition, the conventional 2.5D semiconductor package may suffer higher warpage by large coefficient of thermal expansion (CTE) mismatch between RDL interposer and the die. Therefore, a novel structure for a semiconductor package is desirable to solve the aforementioned problem.

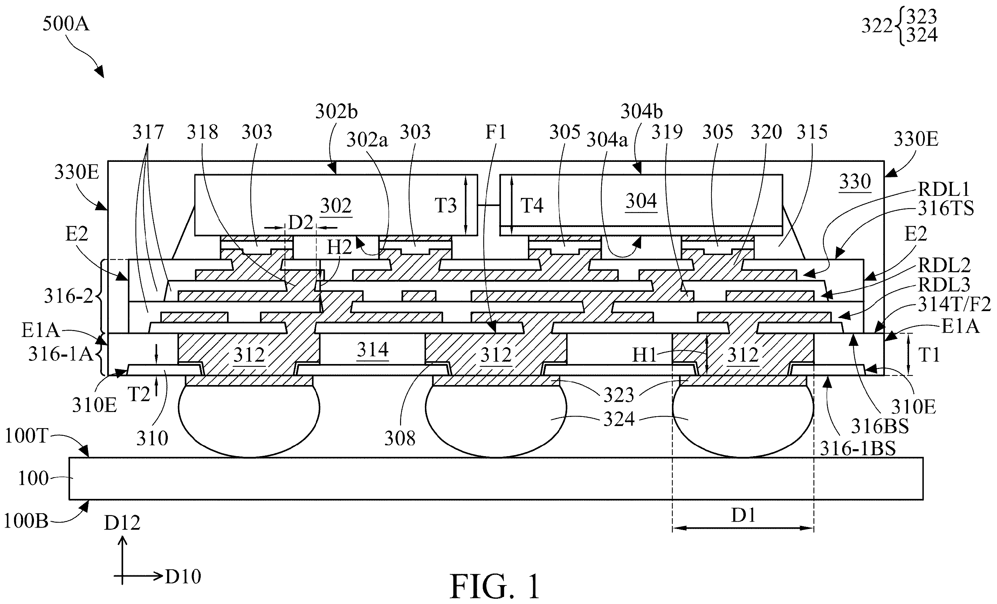

FIG. 1 is schematic cross-sectional view of a semiconductor package 500A in accordance with some embodiments of the disclosure. In some embodiments, the semiconductor package 500A can be used to form a fan-out package, a two-dimensional (2D) package, a 2.5D package, a three-dimensional (3D) semiconductor package, or another suitable package. The semiconductor package 500A may be mounted on a base 100. In some embodiments, the semiconductor package 500A may not include the base 100; that is, the base 100 is external to the semiconductor package 500A. In FIG. 1 and the following figures, directions D10 is defined as horizontal directions (also regarded as the extending directions of conductive layers and/or conductive traces of the semiconductor package 500A), and direction D12 is defined as a vertical direction (also regarded as the extending direction of the through via and/or vias of the semiconductor package 500A).

As shown in FIG. 1, the base 100 can be a single layer or a multilayer structure. In some embodiments, the base 100 is, for example, a printed circuit board (PCB), an interposer, a package substrate, another semiconductor device or a semiconductor package. In some embodiments, the base 100 may be formed of dielectric materials (e.g., polypropylene (PP), epoxy, polyimide, or other applicable resin materials) or semiconductor materials. The base 100 has a top surface 100T and a bottom surface 100B opposite the top surface 100T. The base 100 is provided for the semiconductor package 500A disposed on the top surface 100T. A plurality of conductive traces (not shown), conductive vias and/or conductive pads (not shown) are disposed in the base 100. The conductive traces may be electrically connected to the corresponding conductive vias and conductive pads. The conductive pads and/or the conductive traces are exposed to openings of solder mask layers (not shown) disposed close to the top surface 100T and the bottom surface 100B. In one embodiment, the conductive traces may comprise signal trace segments or ground trace segments, which are used for the input/output (I/O) connections of the semiconductor package 500A. Also, the conductive pads are disposed on the top surface 100T of the base 100, connected to different terminals of the conductive traces. The conductive pads are used for the semiconductor package 500A that is mounted directly on them.

As shown in FIG. 1, the semiconductor package 500A is mounted on the base 100 through a bonding process that uses conductive bump structures 322. The semiconductor package 500A includes a first die 302, a second die 304, a redistribution layer (RDL) structure 316-2, a stress buffer structure 316-1A, a molding compound 330, and the conductive bump structures 322.

The conductive bump structures 322 are in contact with and electrically connected (or coupled) to the stress buffer structure 316-1A and the base 100. In some embodiments, the conductive bump structures 322 comprise a conductive ball structure such as a copper ball, a conductive bump structure such as a copper bump or a solder bump structure. For example, the conductive bump structures 322 may be controlled collapse chip connection (C4) structures. In some embodiments, each of the conductive bump structures 322 may include an under bump metallurgy (UBM) layer 323 and a conductive ball structure 324 on the under bump metallurgy (UBM) layer 323.

In some embodiments, the under bump metallurgy (UBM) layer 323 includes a seed layer (not shown), such as a pure copper (Cu) layer, a pure titanium (Ti) layer, a Ti/Cu layer, a TiW/Cu layer, any other metal layer, and combinations thereof. In some other embodiments, the under bump metallurgy (UBM) layer 323 include a nickel (Ni) layer is formed on the seed layer. In some embodiments, the under bump metallurgy (UBM) layer 323 is formed using a deposition method that includes physical vapor deposition (PVD), such as a sputtering or plating method.

In some embodiments, the conductive ball structure 324 is formed on the under bump metallurgy (UBM) layer 323 using a solder plating process or a screen printing process, a photoresist stripping process, and a solder reflow process.

As shown in FIG. 1, the stress buffer structure 316-1A is disposed on the conductive bump structures 322, and the RDL structure 316-2 is disposed on the stress buffer structure 316-1A. The RDL structure 316-2 is provided for the first die 302 and the second die 304 mounted on it to redistribute and fan-out one or more of die pads of the first die 302 and the second die 304 with a small pitch.

In some embodiments, the stress buffer structure 316-1A is located between the conductive bump structures 322 and the RDL structure 316-2. The RDL structure 316-2 is located between the first die 302 (and/or the second die 304) and the stress buffer structure 316-1A. The stress buffer structure 316-1A is used to release the stress from the base 100 during the bonding process, thereby preventing the first die 302 and the second die 304 from damage. The RDL structure 316-2 is used to redistribute the die pads the first die 302 and the second die 304 having a smaller pitch to the conductive pads of the RDL structure 316-2 which are coupled to the corresponding conductive bump structures 322 having a larger pitch. In some embodiments, there is no specific limitation on the number of dies that can be included in the semiconductor package 500A, and the semiconductor package 500A can contain one, two, or more dies. In this embodiment, two dies are used as an example. For semiconductor packages with multiple dies, the structure described in this embodiment can offer enhanced buffering and protection.

The RDL structure 316-2 may have opposite surfaces 316TS and 316BS. The surface 316TS of the RDL structure 316-2 is provided for the first die 302 and the second die 304 directly to be disposed upon and is also called a die attached surface. The surface 316BS of the RDL structure 316-2 is provided for the stress buffer structure 316-1A directly to be disposed upon and is also called a stress buffer attached surface.

As shown in FIG. 1, the stress buffer structure 316-1A is located close to the surface 316BS of the RDL structure 316-2 and the conductive bump structures 322. The RDL structure 316-2 is disposed on the stress buffer structure 316-1A. In addition, the RDL structure 316-2 is located close to the surface 316TS of the RDL structure 316-2. The stress buffer structure 316-1A may have a bottom surface 316-1BS and a top surface 314T opposite to the bottom surface 316-1BS. The top surface 314T of the stress buffer structure 316-1A may be directly in contact with the surface 316BS of the RDL structure 316-2. The bottom surface 316-1BS of the stress buffer structure 316-1A is provided for the conductive bump structures 322 (or the UBM layer 323) directly to be disposed upon and is also called a ball attached surface.

In some embodiments, the RDL structure 316-2 and the stress buffer structure 316-1A may be formed a mesa structure (raised plateau-like structure). The RDL structure 316-2 rises above the stress buffer structure 316-1A that surrounds the RDL structure 316-2. As shown in FIG. 1, the RDL structure 316-2 partially covers the stress buffer structure 316-1A. The peripheral region of the surface (top surface) 314T of the stress buffer structure 316-1A may be exposed from the RDL structure 316-2. In addition, sidewalls E1A of the stress buffer structure 316-1A are not level with the corresponding sidewalls E2 of the RDL structure 316-2. In some embodiments, the sidewalls E1A of the stress buffer structure 316-1A may be higher than the corresponding the sidewalls E2 of the RDL structure 316-2 in the direction D10 to provide sufficient protect to the RDL structure 316-2 and the first die 302 (and/or the second die 304). Alternatively, the sidewalls E1A of the stress buffer structure 316-1A may protrude beyond the corresponding sidewalls E2 of the RDL structure 316-2 in direction D10. In some embodiments, in a plan view, the size (or the area) of the stress buffer structure 316-1A is larger than the size (or the area) of the RDL structure 316-2, the size (or the area) of the RDL structure 316-2 is larger than the size (or the area) of the first die 302 or multiple dies, and the size (or the area) of the molding compound 330 is equal to the size (or the area) of the stress buffer structure 316-1A.

In some embodiments, the stress buffer structure 316-1A at least includes a stress buffer layer 314 and one or more conductive studs 312.

The stress buffer layer 314 is disposed between the RDL structure 316-2 and the conductive bump structures 322. In some embodiments, the stress buffer layer 314 may be formed of polyimide (PI), polybenzoxazole (PBO), glass fiber, epoxy resin, FR4, molding compound. In some embodiments, the stress buffer layer 314 may be formed of molding compound to enhance mechanical strength and simplify the manufacturing process. In some embodiments, the coefficient of thermal expansion (CTE) of the stress buffer layer 314 may be between the coefficient of thermal expansion of silicon (3.5~4.5 ppm/°C) and the coefficient of thermal expansion of the base (the CTE of a PCB is 12~24 ppm/°C). In other words, the coefficient of thermal expansion (CTE) of the stress buffer layer 314 may be between 3.5 and 24 ppm/°C.

The conductive stud 312 may be formed passing through the stress buffer layer 314. Opposite ends of the conductive stud 312 may be exposed form the stress buffer layer 314. In some embodiments, the conductive stud 312 may be formed of a conductive material, such as metals comprising copper, gold, silver, or other applicable metals. In some embodiments, there may be no other active devices (such as chips, dies, or functional circuits) within the stress buffer layer 314, to avoid damage to these active devices. In some embodiments, the stress buffer structure 316-1A may not include other connecting structures (such as metal layers) to ensure adequate buffering and protection, as well as stable electrical connections. However, the description provided above is not intended to limit the scope of the present disclosure. Skilled practitioners may modify and adapt the described configurations as necessary.

As shown in FIG. 1, the conductive stud 312 has a thickness H1 and a diameter D1. In some embodiments, the thickness H1 is within a range of about 10 um to about 220 um. The diameter D1 is within a range of about 15 um to about 300 um. In some embodiments, the thickness H1 of the conductive stud 312 may be smaller than the thickness T3 of the first die 302 and the thickness of the second die 304. For example, the conductive stud 312 is within a range of about 10 um to about 60 um. In some embodiments, the thickness H1 may be smaller than the thickness of the first die 302 (and/ the second die 304) to decrease the total height of the semiconductor package and increase structural stability.

In some embodiments, the stress buffer structure 316-1A may further include a passivation layer 310. The passivation layer 310 may be used to prevent the conductive stud 312 from oxidation. The passivation layer 310 is disposed on the stress buffer layer 314 and close to the conductive bump structure 322. The thickness T1 of the stress buffer layer 314 may be greater than the thickness T2 of the passivation layer 310. In some embodiments, thickness T1 of the stress buffer layer 314 is greater than or equal to 10 µm. For example, the thickness T1 of the stress buffer layer 314 is within a range of about 10 µm to about 60 µm. The passivation layer 310 may surrounds a portion of the conductive stud 312 close to the conductive bump structure 322. In addition, outer sidewalls 310E of the passivation layer 310 may be surrounded by the stress buffer layer 314. In some embodiments, the surface of the passivation layer 310 exposed from the stress buffer layer 314 forms the surface 316-1BS of the stress buffer structure 316-1A. In some embodiments, the passivation layer 310 may be formed of polyimide (PI) or other applicable passivation materials. In some embodiments, the conductive studs 312 are in contact with the conductive bump structures 322 by passing though the passivation layer 310. In some embodiments, a seed layer 308 is disposed between the passivation layer 310 and the conductive stud 312, and the conductive stud 312 is not in contact with the passivation layer 310.

In some embodiments, the RDL structure 316-2 may include one or more RDL layers (e.g. RDL layers RDL1, RDL2 and RDL3 shown in FIG. 1) alternatively arranged with one or more dielectric layers 317, and conductive pads 320. The RDL layers RDL1, RDL2 and RDL3 include conductive traces 319 and one or more conductive vias 318 disposed in one or more dielectric layers 317. The conductive vias 318 are electrically connected (or coupled) to the conductive stud 312 and the conductive traces 319 at different levels. The conductive traces 319 are electrically connected (or coupled) to the corresponding conductive pads 320. The conductive pads 320 are exposed to openings of the solder mask layer (not shown) and close to the dies 302 and 304.

In some embodiments, the stress buffer layer 314 is disposed between the RDL layers RDL1, RDL2 and RDL3 and the conductive bump structures 322. The RDL layers RDL1, RDL2 and RDL3 is connected (or coupled) to the conductive bump structures 322 via the conductive stud 312. In some embodiments, the conductive via 318 disposed in the dielectric layer 317 closest to the conductive stud 312 may be in contacted with and directly coupled to the correspond conductive stud 312. There is no conductive pad connected between the conductive stud 312 of the stress buffer structure 316-1A and the corresponding conductive via 318. In other words, the conductive stud 312 of the stress buffer structure 316-1A is not in contacted with any conductive pad of the RDL structure 316-2.

In some embodiments, the conductive vias 318 of the RDL structure 316-2 are no larger than the conductive stud 312. As shown in FIG. 1, the conductive vias 318 have a thickness H2 and a diameter D2. In some embodiments, thickness H2 of the conductive vias 318 is not larger than thickness H1 of the conductive stud 312. For example, the thickness H2 may be within a range of about 5 um to about 10 um. In some embodiments, the diameter D2 of the conductive vias 318 is not larger than the diameter D1 of the conductive stud 312. For example, the diameter D2 is within a range of about 5 µm to about 180 µm.

In some embodiments, the material of the conductive vias 318, the conductive traces 319 and the conductive pads 320 of the RDL structure 316-2 may be the same or similar to the material of the conductive stud 312. In some embodiments, the material of the dielectric layers 317 may be the same or similar to the material of the passivation layer 310. It should be noted that in the interposer 316, the number of conductive vias 318, the number of conductive traces, the number of conductive pads 320 and the number of dielectric layers 317 shown in FIG. 1 are only an example and is not a limitation to the present disclosure.

The first die 302 and the second die 304 arranged side-by-side as shown in FIG. 1 in the direction D10. The first die 302 has an active surface 302a and a backside surface 302b opposite to the active surface 302a. The second die 304 has an active surface 304a and a backside surface 304b opposite to the active surface 304a. In some embodiments, the first die 302 and the second die 304 are fabricated using flip-chip technology, and they are flipped to be disposed on the RDL structure 316-2 opposite the conductive bump structures 322. The active surface 302a and 304a may face the RDL structure 316-2. In other words, the conductive bump structures 322 are disposed on the conductive studs 312 of the stress buffer structure 316-1A and opposite the first die 302 and the second die 304. In addition, the RDL structure 316-2 and the stress buffer structure 316-1A are disposed between the first die 302, the second die 304 and the conductive bump structures 322. The conductive bump structures 322 are electrically connected to the first die 302 and the second die 304 by the conductive studs 312 of the stress buffer structure 316-1A and the stress buffer structure 316-1A and the RDL structure 316-2.

In some embodiments, the first die 302 and the second die 304 have different functions. For example, the first die 302 includes a logic die, and the second die 304 includes a memory die. The logic die may include a system-on-chip (SoC), a central processing unit (CPU) die, a graphic processing unit (GPU) die, a radio frequency (RF) die, a micro control unit (MCU) die, a microprocessor unit (MPU) die, a power management integrated circuit (PMIC) die, a global positioning system (GPS) device, or an application processor (AP) die, or any combination thereof. The memory die may include a dynamic random access memory (DRAM) die, a high bandwidth memory (HBM) die, the like, or any combination thereof. For example, the second die 304 may be HBM2 or HBM3, but not limited thereto. HBM is a memory chip with low power consumption and ultra-wide communication lanes.

In some embodiments, the first die 302 may be mounted on the RDL structure 316-2 by conductive bump structures 303. The second die 304 may be mounted on the RDL structure 316-2 by conductive bump structures 305. The conductive bump structures 303 and 305 are in contact with and coupled to the conductive pads 320 of the RDL structure 316-2.

In some embodiments, the conductive bump structures 303 and 305 may include microbumps. In some embodiments, each of the conductive bump structures 303 and 305 may include an under bump metallurgy (UBM) structure (not shown) and a conductive ball structure (not shown) on the UBM structure. In some embodiments, the conductive bump structures 303 and 305 may include materials such as nickel, copper, gold, palladium, SnAg solder, or a combination thereof.

As shown in FIG. 1, the semiconductor package 500A further includes an underfill 315 filling the gap between the first die 302 and the RDL structure 316-2, and the gap between the second die 304 and the RDL structure 316-2. The underfill 315 may partially fill the gap between the first die 302 and the second die 304. In some embodiments, the underfill 315 surrounds a portion of the first die 302, a portion of the second die 304, and the conductive bump structures 303 and 305 and is in contact with a portion of the RDL structure 316-2 to further reduce the thermal resistance from the first die 302 and the second die 304 to the RDL structure 316-2. In addition, the underfill 315 may be disposed to compensate for differing coefficients of thermal expansion (CTEs) between the first die 302, the second die 304, the conductive bump structures 303, 305 and the RDL structure 316-2.

As shown in FIG. 1, the molding compound 330 is disposed on the stress buffer structure 316-1A and the RDL structure 316-2. In addition, the molding compound 330 surrounds and is in contact with the first die 302 and the second die 304. The active surface 302a of the first die 302 and the active surface 304a of the second die 304 may be covered by or exposed form the molding compound 330. In some embodiments, the molding compound 330 is in contact with the surface 316TS of the RDL structure 316-2 exposed form the first die 302, the second die 304 and the underfill 315. The molding compound 330 surrounds and is in contact with the sidewalls E2 of the RDL structure 316-2. In addition, the molding compound 330 is in contact with the surface (top surface) 314T of the stress buffer structure 316-1A without covered by the RDL structure 316-2. Furthermore, the sidewalls E1A of the stress buffer structure 316-1A may be exposed from the molding compound 330. In some embodiments, sidewalls 330E of the molding compound 330 are level with the corresponding sidewalls E1A of the stress buffer structure 316-1A. In other words, the molding compound 330 is not surround the sidewalls E1A of the stress buffer structure 316-1A. In some embodiments, the RDL structure 316-2 is in contact with the stress buffer structure 316-1A, and the molding compound 330 is in contact with the stress buffer structure 316-1A.

In some embodiments, the RDL structure 316-2 and the molding compound 330 are in contact with different portions of the surface 314T of the stress buffer structure 316-1A. In other words, the interface F1 between the RDL structure 316-2 and the stress buffer structure 316-1A is level with the interface F2 between the molding compound 330 and the stress buffer structure 316-1A. In some embodiments, the RDL structure 316-2 and the stress buffer structure 316-1A are formed in different process steps, with the interface F1 being established between them. In some embodiments, the RDL structure 316-2 and the molding compound 330 are formed in different process steps, with the interface F2 being established between them. In some embodiments, the RDL structure 316-2, the stress buffer structure 316-1A and the molding compound 330 are formed in different process steps. In some embodiments, the RDL structure 316-2 and the molding compound 330 together cover the entire top surface 314T of the stress buffer structure 316-1A. Therefore, the semiconductor package 500A has better structural stability.

In some embodiments, the molding compound 330 may be formed of a nonconductive material, such as an epoxy, a resin, a moldable polymer, or the like. The molding compound 330 may be applied while substantially liquid, and then may be cured through a chemical reaction, such as in an epoxy or resin. In some other embodiments, the molding compound 330 may be an ultraviolet (UV) or thermally cured polymer applied as a gel or malleable solid capable of being disposed around the first die 302 and the second die 304, and then may be cured using a UV or thermally curing process. The molding compound 330 may be cured with a mold (not shown).

In this embodiment, the stress buffer layer 314 of the stress buffer structure 316-1A and the molding compound 330 are formed of the same material, such as molding base materials. In some embodiments, the stress buffer layer 314 may contain glass fiber, and the molding compound 330 may not contain glass fiber.

In some embodiments, the semiconductor package 500A may include the stress buffer structure 316-1A located between the RDL structure 316-2 and the conductive bump structures 322. The stress buffer structure 316-1A includes a stress buffer layer 314 formed of molding base materials. The stress buffer layer 314 may release the stress from the base 100 during the bonding process, thereby preventing the first die 302 and the second die 304 from damage. In some embodiments, the coefficient of thermal expansion (CTE) of the stress buffer layer 314 may be between the coefficient of thermal expansion of silicon and the coefficient of thermal expansion of the base. Therefore, the warpage of the semiconductor package 500A is reduced. In some embodiments, the stress buffer structure 316-1A further includes one or more conductive stud 312 passing through the stress buffer layer 314. The conductive stud 312 having stress buffer function is also used as electrical connections between the conductive vias 318 having a smaller pitch and the conductive bump structures 322 having a larger pitch. The conductive stud 312 is larger than the conductive vias 318. For example, the thickness H1 and/or diameter D1 of the conductive stud 312 is larger than the thickness H2 and/or diameter D2 of the conductive vias 318.

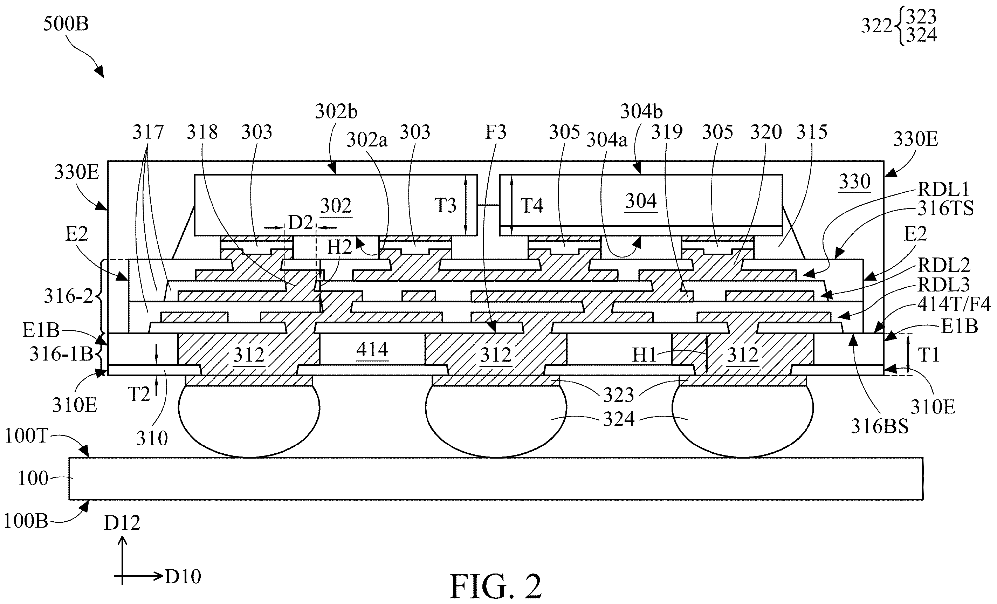

FIG. 2 is a schematic cross-sectional view of a semiconductor package 500B in accordance with some embodiments of the disclosure. Elements of the embodiments hereinafter, that are the same or similar as those previously described with reference to FIG. 1, are not repeated for brevity. As shown in FIGS. 1 and 2, the difference between the semiconductor package 500A and the semiconductor package 500B at least includes that a stress buffer layer 414 of a stress buffer structure 316-1B of the semiconductor package 500B is formed of polymer base material.

The stress buffer layer 414 is disposed between the RDL structure 316-2 and the conductive bump structures 322. In this embodiment, the stress buffer layer 414 and the molding compound 330 are formed of different materials. For example, the stress buffer layer 414 is formed of polyimide (PI), polybenzoxazole (PBO), glass fiber, epoxy resin, FR4 or other suitable materials. In some embodiments, the stress buffer layer 414 may be formed of polymer base material to enhance its ability to buffer and protect the RDL structure 316-2, as well as the first die 302 and/or the second die 304. In some embodiments, the coefficient of thermal expansion (CTE) of the stress buffer layer 414 may be between the coefficient of thermal expansion of silicon (3.5~4.5 ppm/°C) and the coefficient of thermal expansion of the base (the CTE of a PCB is 12~24 ppm/°C). In other words, the coefficient of thermal expansion (CTE) of the stress buffer layer 414 may be between 3.5 and 24 ppm/°C.

In this embodiment, the outer sidewalls 310E of the passivation layer 310 are level with the corresponding sidewalls E1B of the stress buffer structure 316-1B and the corresponding sidewalls 330E of the molding compound 330. The outer sidewalls 310E of the passivation layer 310 may be exposed from the stress buffer layer 414.

In some embodiments, the RDL structure 316-2 and the molding compound 330 are in contact with different portions of the surface 414T of the stress buffer structure 316-1B. In other words, the interface F3 between the RDL structure 316-2 and the stress buffer structure 316-1B is level with the interface F4 between the molding compound 330 and the stress buffer structure 316-1B. In some embodiments, the RDL structure 316-2 and the molding compound 330 together cover the entire top surface 414T of the stress buffer structure 316-1B. Therefore, the semiconductor package 500B has better structural stability.

In some embodiments, the semiconductor package 500B may include the stress buffer structure 316-1B located between the RDL structure 316-2 and the conductive bump structures 322. The stress buffer structure 316-1B includes the stress buffer layer 414 formed of polymer base materials. The stress buffer layer 414 may release the stress from the base 100 during the bonding process, thereby preventing the first die 302 and the second die 304 from damage. In some embodiments, the coefficient of thermal expansion (CTE) of the stress buffer layer 414 may be between the coefficient of thermal expansion of silicon and the coefficient of thermal expansion of the base. Therefore, the warpage of the semiconductor package 500B is reduced. In some embodiments, the stress buffer structure 316-1B further includes one or more conductive stud 312 passing through. The conductive stud 312 is used to form an electrical connection between the conductive vias 318 having a smaller pitch and the conductive bump structures 322 having a larger pitch. The conductive stud 312 is larger than the conductive vias 318.

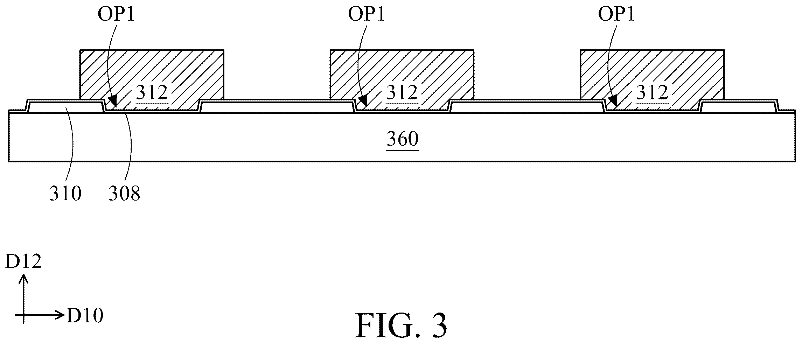

FIGS. 3, 4, 5, 6, 7 and 8 are cross-sectional views of intermediate stages of forming the semiconductor package 500A structure of FIG. 1 in accordance with some embodiments of the disclosure. Elements of the embodiments hereinafter, that are the same or similar as those previously described with reference to FIGS. 1 and 2, are not repeated for brevity.

As shown in FIG. 3, a carrier 360 is provided. In some embodiments, the material of the carrier 360 includes glass. Next, multiple deposition processes are performed to form a passivation layer 310 and a seed layer 308 on the carrier 360 in sequence. The passivation layer 310 has openings OP1, and the seed layer 308 is conformally formed on the passivation layer 310. Next, a photolithography process is performed to form photoresist patterns (not shown) on the seed layer 308 to define formation positions of the subsequent conductive studs 312. The conductive studs 312 are formed on the seed layer 308 by a plating process. After forming the conductive studs 312, the photoresist patterns are removed. Next, an etching process is performed to remove the exposed portions of the seed layer 308 around the conductive studs 312. As a result, a residual portion of seed layer 308 remains between the conductive studs 312 and the carrier 306, as well as between the conductive studs 312 and the passivation layer 310.

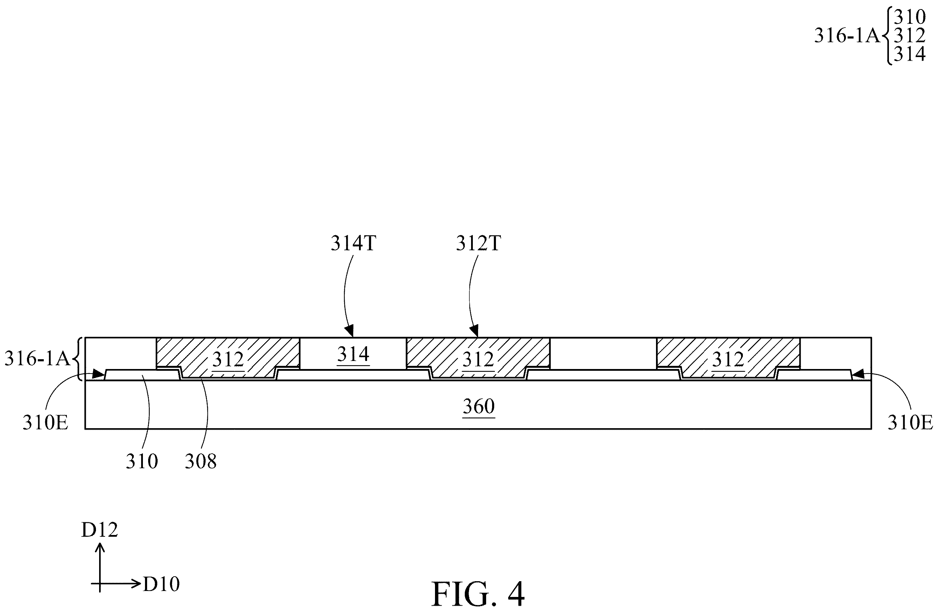

Next, as shown in FIG. 4, a molding process is performed to form a stress buffer layer 314 covering the passivation layer 310 and the conductive stud 312. The stress buffer layer 314 may surround the sidewalls 310E of the passivation layer 310. Next, a planarization process, for example, grinding, is performed to remove a portion of the stress buffer layer 314 until the conductive studs 312 are exposed. After performing the planarization process, surfaces 312T of the conductive studs 312 and the surface 314T of the planarized stress buffer layer 314 away from the carrier 360 are flush with each other. In this embodiment, the passivation layer 310, the conductive stud 312, and the stress buffer layer 314 form a stress buffer structure 316-1A.

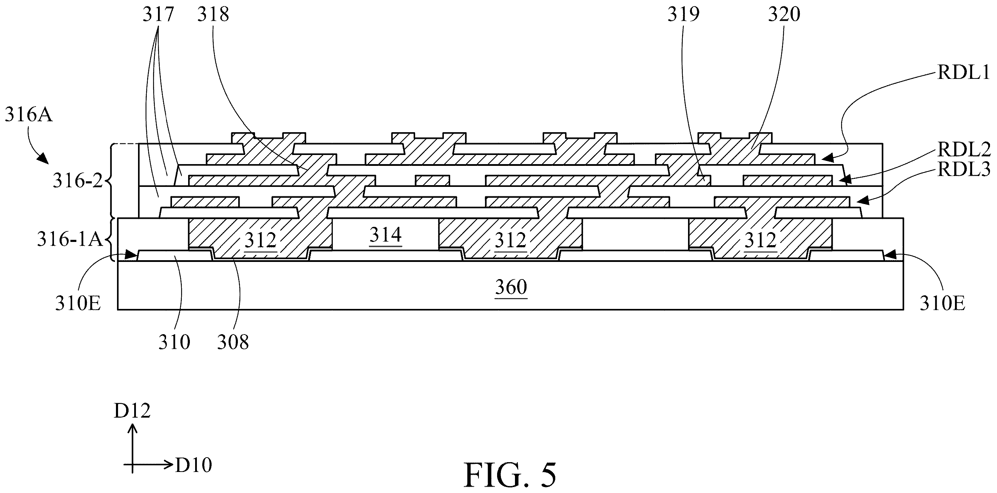

Next, as shown in FIG. 5, multiple deposition and patterning processes are performed to form a RDL structure 316-2 on the conductive stud 312 and the stress buffer layer 314. In some embodiments, the RDL structure 316-2 and the stress buffer structure 316-1A are formed in separate process steps, with the interface F1(as shown in FIG. 1) being established between them.

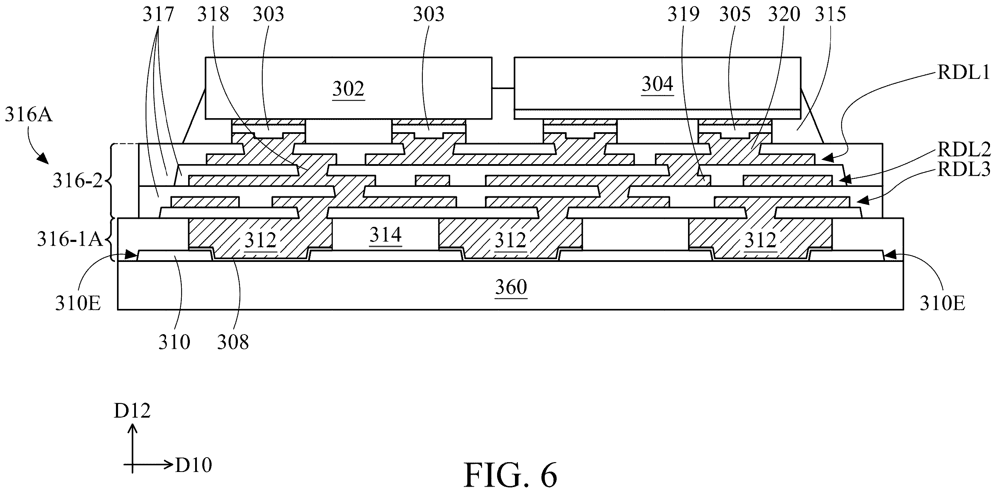

Next, as shown in FIG. 6, a first die 302 and a second die 304, along with conductive bump structures 303 and 305, are side-by-side disposed on the redistribution layer (RDL) structure 316-2. Next, a solder reflow process is performed so that the first die 302, the second die 304 are coupled to the conductive pads 230 by the conductive bump structures 303 and 305. Next, an underfill 315 is introduced (dispensed) into gaps between the first die 302, the second die 304 and the redistribution layer (RDL) structure 316-2 by an underfilling process.

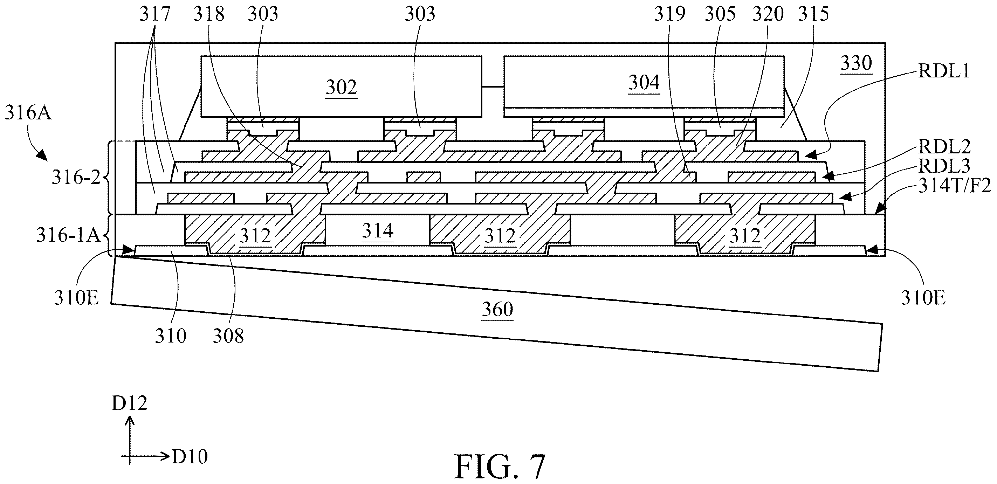

Next, as shown in FIG. 7, another molding process is performed to form a molding compound 330 on the stress buffer structure 316-1A and the RDL structure 316-2. The molding compound 330 surrounds the RDL structure 316-2, the first die 302 and the second die 304. In addition, the molding compound 330 covers the surface 314T of the stress buffer structure 316-1A without covered by the RDL structure 316-2. Next, the carrier 360 is removed from the RDL structure 316-2. In some embodiments, the stress buffer structure 316-1A and the molding compound 330 are formed in different process steps, with the interface F2 (as shown in FIG. 1) being established between them.

In some embodiments in which the stress buffer layer 314 of the stress buffer structure 316-1A and the molding compound 330 are formed of the same material, the interface F2 between the stress buffer layer 314 of stress buffer structure 316-1B and the molding compound 330 is still visible because the surface 314T of the stress buffer layer 314 is subjected to a planarization process (e.g., grinding) before the formation of the molding compound 330.

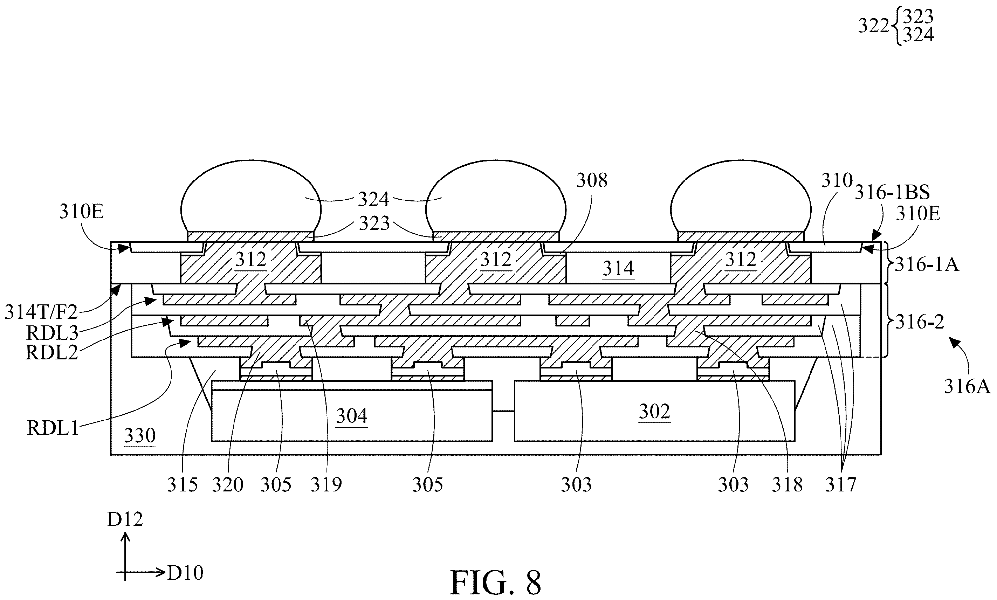

Next, as shown in FIG. 8, the intermediate structure shown in FIG. 7 is flipped again. Next, a bumping process is performed to form the conductive bump structure 322 including an under bump metallurgy (UBM) layer 323 and a conductive ball structure 324 on the conductive stud 312 of the stress buffer structure 316-1A and opposite the first die 302 and the second die 304. In some embodiments, a residual portion of the seed layer 308 may remain between the conductive stud 312 and the passivation layer 310. In some embodiments, the residual portion of the seed layer 308 may also remain between the conductive stud 312 and the UBM layer 323.

In some embodiments, the bumping process includes forming the under bump metallurgy (UBM) layer 323 on the conductive stud 312 exposed from the opening of the passivation layer 310 and opposite the RDL structure 316-2 using a deposition method. The under bump metallurgy (UBM) layer 323 may also extend onto the surface 316-1BS of the stress buffer structure 316-1A.

As shown in FIG. 8, next, the bumping process further includes forming the conductive ball structure 324 on the under bump metallurgy (UBM) layer 323 using a solder plating process, a photoresist stripping process, and a solder reflow process.

Next, a singulation process is performed to dice the molding compound 330 and the stress buffer structure 316-1A at the interface F2 between the molding compound 330 and the stress buffer layer 314 of the stress buffer structure 316-1A along the direction D12 that is substantially perpendicular the interface F2 between the molding compound 330 and the stress buffer layer 314 of the stress buffer structure 316-1A. In some embodiments, the singulation process may not dice the RDL structure 316-2 and the passivation layer 310 of the stress buffer structure 316-1A. After performing the aforementioned processes, a discrete semiconductor package 500A including the RDL structure 316-2 and the stress buffer structure 316-1A as shown in FIG. 1 is formed.

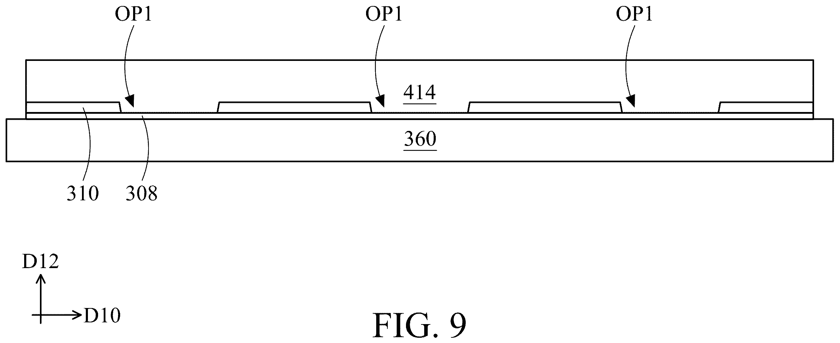

FIGS. 9, 10, 11, 12, 13 and 14 are cross-sectional views of intermediate stages of forming the semiconductor package 500B of FIG. 2 in accordance with some embodiments of the disclosure. Elements of the embodiments hereinafter, that are the same or similar as those previously described with reference to FIGS. 1 to 8, are not repeated for brevity.

As shown in FIG. 9, a carrier 360 is provided. In some embodiments, the material of the carrier 360 includes glass. Next, multiple deposition processes are performed to form a seed layer 308 and a passivation layer 310 on the carrier 360 in sequence. Next, a photolithography process is performed to form photoresist patterns (not shown) on the passivation layer 310 to define formation positions of the following conductive studs 312. Next, an etching process is performed to form one or more openings OP1 passing through the passivation layer 310 to expose a portion of the seed layer 308.

Next, a lamination process is performed to form a fabricated stress buffer layer 414 covering the passivation layer 310 and the seed layer 308 exposed from the openings OP1 of the passivation layer 310. Outer sidewalls 310E of the passivation layer 310 may be exposed from the stress buffer layer 414.

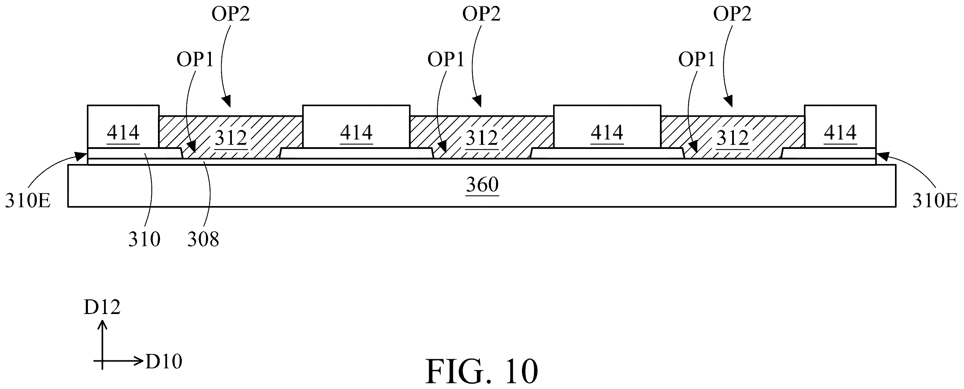

As shown in FIG. 10, next, a patterning process is performed to form one or more openings OP2 passing through the stress buffer layer 414. In some embodiments, the openings OP2 are aligned with the corresponding openings OP1 in the direction D12.

Next, a plating process is performed to form one or more conductive studs 312 on the seed layer 308 in the openings OP1 of the passivation layer 310 and the openings OP2 of the stress buffer layer 414. In some embodiments, the conductive studs 312 completely fill the openings OP1 of the passivation layer 310. In addition, the openings OP1 of the passivation layer 310 may completely or partially fill the openings OP2 of the stress buffer layer 414.

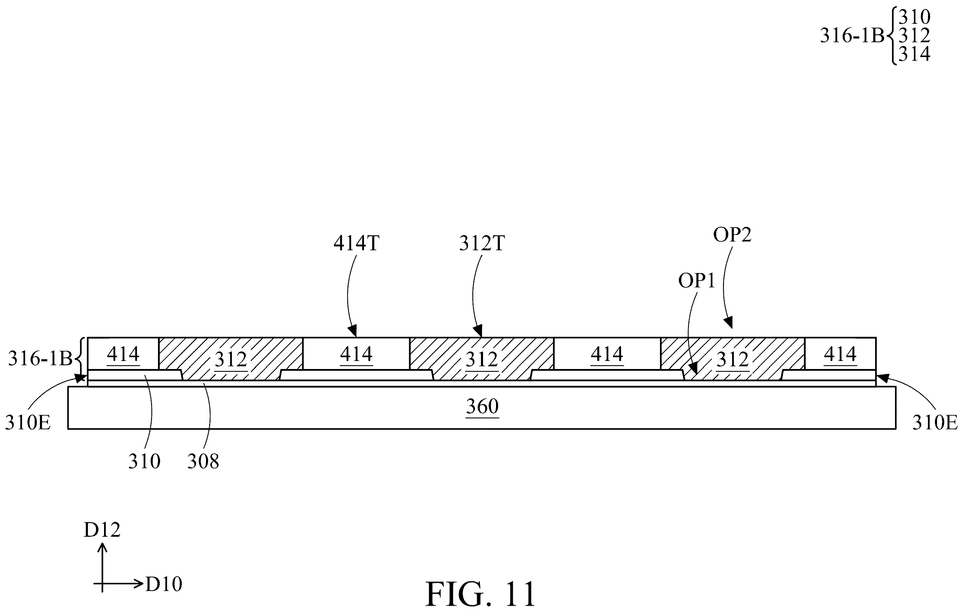

As shown in FIG. 11, next, a planarization process, such as chemical mechanical polishing (CMP), is performed to remove a portion of the stress buffer layer 414 and a portion of the conductive studs 312, so that the surface 414T of the planarized stress buffer layer 414 and surfaces 312T of the planarized conductive studs 312 away from the carrier 360 are flush with each other. In this embodiment, the passivation layer 310, the conductive stud 312, and the stress buffer layer 414 form a stress buffer structure 316-1B.

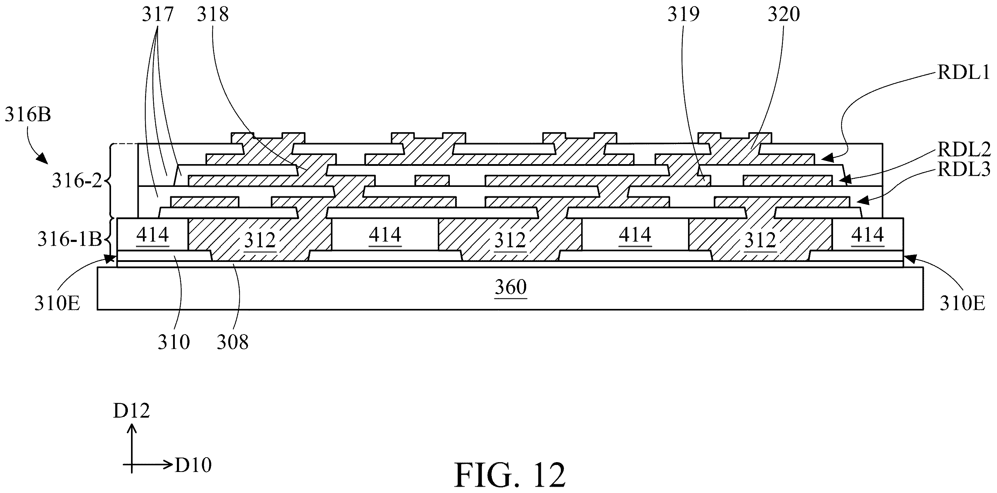

Next, as shown in FIG. 12, multiple deposition and patterning processes are performed to form a RDL structure 316-2 on the conductive stud 312 and the stress buffer layer. In some embodiments, the RDL structure 316-2 and the stress buffer structure 316-1A are formed in separate process steps, with the interface F3 (as shown in FIG. 2) being established between them.

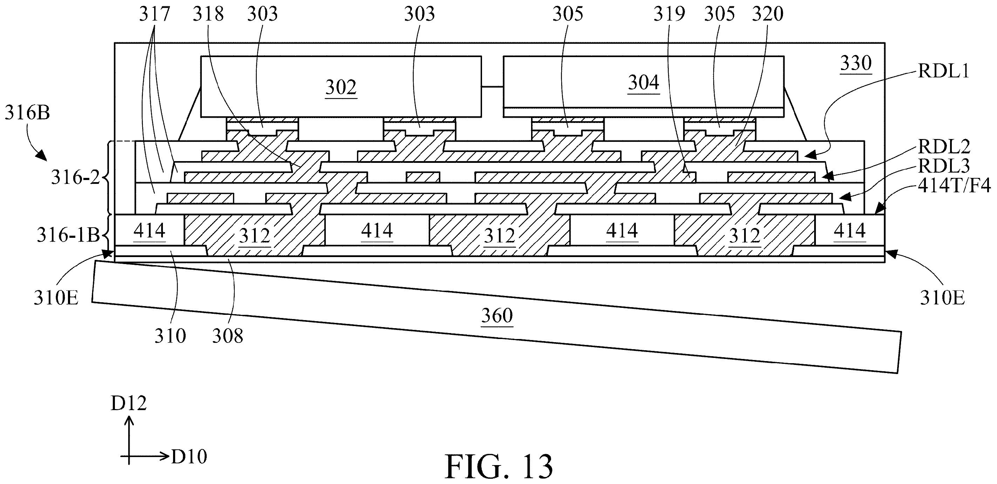

Next, as shown in FIG. 13, a first die 302 and a second die 304, along with conductive bump structures 303 and 305, are disposed on the redistribution layer (RDL) structure 316-2. Next, a solder reflow process is performed so that the first die 302, the second die 304 are coupled to the conductive pads 230 by the conductive bump structures 303 and 305. Next, an underfill 315 is introduced (dispensed) into gaps between the first die 302, the second die 304 and the redistribution layer (RDL) structure 316-2 by an underfilling process.

Next, as shown in FIG. 13, a molding process is performed to form a molding compound 330 on the stress buffer structure 316-1B and the RDL structure 316-2. The molding compound 330 surrounds the RDL structure 316-2, the first die 302 and the second die 304. In addition, the molding compound 330 covers the surface 414T of the stress buffer structure 316-1B without covered by the RDL structure 316-2. Next, the carrier 360 is removed from the RDL structure 316B. In some embodiments, the stress buffer structure 316-1A and the molding compound 330 are formed in different process steps, with the interface F4 (as shown in FIG. 2) being established between them.

In this embodiment, the stress buffer layer 414 of the stress buffer structure 316-1B and the molding compound 330 are formed of the different materials. In addition, the surface 414T of the stress buffer layer 414 is subjected to a planarization process (e.g., chemical mechanical polishing (CMP)) before the formation of the molding compound 330, and the interface F3 between the stress buffer layer 414 of the stress buffer structure 316-1B and the molding compound 330 is visible.

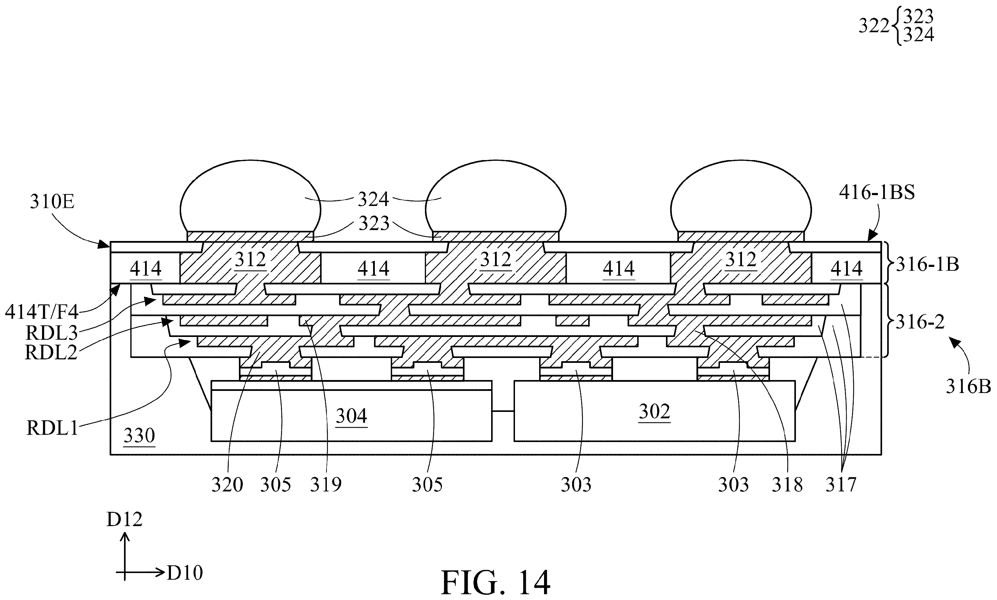

Next, as shown in FIG. 14, the intermediate structure shown in FIG. 13 is flipped again. Next, a bumping process is performed to form the conductive bump structure 322 including an under bump metallurgy (UBM) layer 323 and a conductive ball structure 324 on the conductive stud 312 of the stress buffer structure 316-1B and opposite the first die 302 and the second die 304.

In some embodiments, the bumping process includes forming the under bump metallurgy (UBM) layer 323 on the conductive stud 312 exposed from the opening of the passivation layer 310 and opposite the RDL structure 316-2 using a deposition method. The under bump metallurgy (UBM) layer 323 may also extend onto the surface 416-1BS of the stress buffer structure 316-1B.

As shown in FIG. 14, next, the bumping process further includes forming the conductive ball structure 324 on the under bump metallurgy (UBM) layer 323 using a solder plating process, a photoresist stripping process, and a solder reflow process. In some embodiments, as shown in FIG. 14, no residual seed layer 308 exists.

Next, a singulation process is performed to dice the molding compound 330 and the stress buffer structure 316-1B at the interface F3 between the molding compound 330 and the stress buffer layer 414 of the stress buffer structure 316-1B along the direction D12 that is substantially perpendicular the interface F3 between the molding compound 330 and the stress buffer layer 414 of the stress buffer structure 316-1B. In some embodiments, the singulation process may not dice the RDL structure 316-2 and the passivation layer 310 of the stress buffer structure 316-1B . After performing the aforementioned processes, a discrete semiconductor package 500B including the RDL structure 316B and the stress buffer structure 316-1B as shown in FIG. 2 is formed.

Embodiments provide a semiconductor package and a method for forming the same. The semiconductor package includes a redistribution layer (RDL) structure (e.g., RDL structures 316-2), a first die (e.g., die 302 or 304), a stress buffer structure (e.g., stress buffer structure 316-1A or 316-1B) and a conductive bump structure (e.g., conductive bump structure 322). The RDL structure has a first surface (e.g., surface 316TS) and a second surface (e.g., surface 316BS). The first surface is opposite the second surface. The first die is disposed on the first surface of the RDL structure. The stress buffer structure is disposed on the second surface of the RDL structure. The stress buffer structure includes a stress buffer layer (e.g., stress buffer layer 314 or 414) and a conductive stud (e.g., conductive stud 312) passing through the stress buffer layer. The conductive bump structure is disposed on the conductive stud and opposite to the first die. The conductive bump structure is electrically coupled to the first die by the stress buffer structure and the RDL structure..

In some embodiments, the RDL structure includes a conductive via (e.g., conductive via 318) whose size (e.g., its thickness H2 and/or diameter D2) is smaller than that (e.g., the thickness H1 and/or diameter D1) of the conductive stud.

In some embodiments, sidewalls of the stress buffer structure protrude beyond the corresponding sidewalls of the RDL structure, and the RDL structure partially covers the stress buffer structure.

In some embodiments, sidewalls of the stress buffer structure are not level with the corresponding sidewalls of the RDL structure.

In some embodiments, the coefficient of thermal expansion (CTE) of the stress buffer layer is between 3.5 and 24 ppm/°C. The thickness of stress buffer layer is greater than or equal to 10 µm.

In some embodiments, the semiconductor package further includes a second die and a molding compound. The second die is arranged side-by-side with the first die. The molding compound is disposed on the stress buffer structure the RDL structure and surrounds the first die.

In some embodiments, the molding compound surrounds the RDL structure and is in contact with the stress buffer layer.

In some embodiments, the sidewalls of the molding compound are level with the corresponding sidewalls of the stress buffer structure.

In some embodiments, the stress buffer layer and the molding compound are formed of the same material.

In some embodiments, the stress buffer layer and the molding compound are formed of different materials.

In some embodiments, the stress buffer layer is formed of a molding compound or polymer matrix. The stress buffer layer includes polyimide (PI), polybenzoxazole (PBO), glass fiber, epoxy resin, FR4, molding compound or a combination thereof.

In some embodiments, the interface between the stress buffer layer and the RDL structure is level with the interface between the stress buffer layer and the molding compound.

In some embodiments, the RDL structure and the molding compound together cover the entire top surface of the stress buffer structure.

In some embodiments, the RDL structure is in contact with the stress buffer structure, and the molding compound is in contact with the stress buffer structure.

In some embodiments, the material of the stress buffer layer is selected from polyimide (PI), polybenzoxazole (PBO), glass fiber, epoxy resin, FR4, molding compound or a combination thereof.

In some embodiments, the semiconductor package further includes a passivation layer. The passivation layer is disposed on the stress buffer layer and surrounding a portion of the conductive stud. The conductive stud is in contact with the conductive bump structure by passing though the passivation layer.

In some embodiments, the conductive via is coupled to the conductive bump structure via the conductive stud.

In some embodiments, the surface of the passivation layer exposed from the stress buffer layer forms the bottom surface of the stress buffer structure.

In some embodiments, the passivation layer surrounds a portion of the conductive stub close to the bottom surface of the stress buffer structure.

In some embodiments, the thickness of the conductive stud is smaller than the thickness of the first die.

In some embodiments, conductive layers of the RDL structure are coupled to the conductive bump structure via the conductive stud.

In some embodiments, the first die joint is connected to the RDL structure via another conductive bump structure.

In some embodiments, the semiconductor package further includes an underfill dispense under the first die area.

In some embodiments, the molding compound surrounds the first die, optionally encapsulating the RDL structure.

Embodiments provide a method for forming a semiconductor package. The method includes forming a conductive stud and a stress buffer layer surrounding the conductive stud on a carrier. The conductive stud and the stress buffer layer form a stress buffer structure. The method further includes forming a redistribution layer (RDL) structure on the conductive stud and the stress buffer layer. The method further includes disposing a first die on the redistribution layer (RDL) structure. The method further includes forming a conductive bump structure on the conductive stud of the stress buffer structure and opposite to the first die.

In some embodiments, the formation of the conductive stud and the stress buffer layer surrounding the conductive stud on the carrier includes forming a passivation layer and a seed layer on the carrier in sequence. The passivation layer has an opening. The method further includes forming the conductive stud on the seed layer. The method further includes forming a stress buffer layer covering the passivation layer and the conductive stud. The method further includes removing a portion of the stress buffer layer until the conductive stud is exposed.

In some embodiments, the formation of the conductive stud and the stress buffer layer surrounding the conductive stud on the carrier includes forming a seed layer and a passivation layer on the carrier in sequence. The passivation layer has a first opening exposing a portion of the seed layer. The method further includes forming a stress buffer layer covering the passivation layer and the seed layer exposed from the first opening of the passivation layer. The method further includes forming a second opening passing through the stress buffer layer. The second opening is aligned with the first opening. The method further includes forming the conductive stud on the seed layer in the first opening of the passivation layer and the second opening of the stress buffer layer. The method further includes removing a portion of the stress buffer layer and a portion of the conductive stud, so that surfaces of the stress buffer layer and conductive stud away from the carrier are flush with each other.

In some embodiments, the method further includes forming a molding compound on the stress buffer structure. The molding compound surrounds the RDL structure and the first die. The method further includes removing the carrier from the stress buffer structure.

The method further includes dicing the molding compound and the stress buffer structure at the interface between the molding compound and the stress buffer layer of the stress buffer structure along a direction that is substantially perpendicular the interface between the molding compound and the stress buffer layer of the stress buffer structure.

In some embodiments, the formation of the conductive bump structure further includes forming an under bump metallurgy (UBM) layer on the conductive stud and opposite the RDL structure. The method further includes forming a conductive ball structure on the under bump metallurgy (UBM) layer.

In the semiconductor package, the stress buffer structure located between the RDL structure and the conductive bump structures. The stress buffer structure includes the stress buffer layer and the conductive studs. In some embodiments, the stress buffer layer formed of molding compounds or polymer base materials may release the stress from the base during the bonding process. Therefore, the damage to the dies mounted on the RDL structure is reduced. In some embodiments, the coefficient of thermal expansion (CTE) of the stress buffer layer may be between the coefficient of thermal expansion of silicon (3.5~4.5 ppm/°C) and the coefficient of thermal expansion of the base (the CTE of a PCB is 12~24 ppm/°C). The CTE mismatch issue between the dies and the RDL structure can be minimized. Therefore, the warpage of the semiconductor package is reduced. In addition, except for the stress buffering, the larger conductive stud can be used to form an electrical connection between the conductive vias having a smaller pitch and the conductive bump structures having a larger pitch.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
Clause 1. A semiconductor package, comprising:
   a redistribution layer (RDL) structure having a first surface and a second surface opposite to the first surface;
   a first die disposed on the first surface of the RDL structure;
   a stress buffer structure disposed on the second surface of the RDL structure, wherein the stress buffer structure comprises a stress buffer layer and a conductive stud passing through the stress buffer layer; and
   a conductive bump structure disposed on the conductive stud and opposite to the first die, wherein the conductive bump structure is electrically coupled to the first die by the stress buffer structure and the RDL structure.
Clause 2. The semiconductor package of clause 1, wherein the RDL structure comprises a conductive via having a size smaller than the conductive stud.
Clause 3. The semiconductor package of clause 1, wherein sidewalls of the stress buffer structure protrude beyond the corresponding sidewalls of the RDL structure, and wherein the RDL structure partially covers the stress buffer structure.
Clause 4. The semiconductor package of clause 1, wherein a coefficient of thermal expansion (CTE) of the stress buffer layer is between 3.5 and 24 ppm/°C.
Clause 5. The semiconductor package of clause 1, further comprising:
   a molding compound disposed on the RDL structure and surrounding the first die, wherein the molding compound surrounds the RDL structure and is in contact with the stress buffer layer.
Clause 6. The semiconductor package of clause 5, wherein sidewalls of the molding compound are level with corresponding sidewalls of the stress buffer structure.
Clause 7. The semiconductor package of clause 5, wherein an interface between the stress buffer layer and the RDL structure is level with an interface between the stress buffer layer and the molding compound.
Clause 8. The semiconductor package of clause 5, wherein the RDL structure and the molding compound together cover the entire top surface of the stress buffer structure.
Clause 9. The semiconductor package of clause 5, wherein the RDL structure is in contact with the stress buffer structure, and the molding compound is in contact with the stress buffer structure.
Clause 10. The semiconductor package of clause 1, wherein a material of the stress buffer layer is selected from polyimide (PI), polybenzoxazole (PBO), glass fiber, epoxy resin, FR4, molding compound or a combination thereof.
Clause 11. The semiconductor package of clause 1, further comprising:
   a passivation layer disposed on the stress buffer layer and surrounding a portion of the conductive stud, wherein the conductive stud is in contact with the conductive bump structure by passing though the passivation layer.
Clause 12. The semiconductor package of clause 11, wherein a surface of the passivation layer exposed from the stress buffer layer forms a bottom surface of the stress buffer structure.
Clause 13. The semiconductor package of clause 11, wherein the passivation layer surrounds a portion of the conductive stub close to a bottom surface of the stress buffer structure.
Clause 14. The semiconductor package of clause 1, wherein the thickness of the conductive stud is smaller than the thickness of the first die.
Clause 15. A method for forming a semiconductor package, comprising:
   forming a conductive stud and a stress buffer layer surrounding the conductive stud on a carrier, wherein the conductive stud and the stress buffer layer form a stress buffer structure;
   forming a redistribution layer (RDL) structure on the stress buffer structure;
   disposing a first die on the redistribution layer (RDL) structure; and
   forming a conductive bump structure on the conductive stud of the stress buffer structure and opposite to the first die.
Clause 16. The method for forming a semiconductor package of clause 15, wherein forming the conductive stud and the stress buffer layer surrounding the conductive stud on the carrier comprises:
   forming a passivation layer and a seed layer on the carrier in sequence, wherein the passivation layer has an opening;
   forming the conductive stud on the seed layer;
   forming a stress buffer layer covering the passivation layer and the conductive stud; and
   removing a portion of the stress buffer layer until the conductive stud is exposed.
Clause 17. The method for forming a semiconductor package of clause 15, wherein forming the conductive stud and the stress buffer layer surrounding the conductive stud on the carrier comprises:
   forming a seed layer and a passivation layer on the carrier in sequence, wherein the passivation layer has a first opening exposing a portion of the seed layer;
   forming a stress buffer layer covering the passivation layer and the seed layer exposed from the first opening of the passivation layer;
   forming a second opening passing through the stress buffer layer, wherein the second opening is aligned with the first opening;
   forming the conductive stud on the seed layer in the first opening of the passivation layer and the second opening of the stress buffer layer; and
   removing a portion of the stress buffer layer and a portion of the conductive stud, so that surfaces of the stress buffer layer and conductive stud away from the carrier are flush with each other.
Clause 18. The method for forming a semiconductor package of clause 15, further comprising:
   forming a molding compound on the stress buffer structure, wherein the molding compound surrounds the RDL structure and the first die; and
   removing the carrier from the stress buffer structure.
Clause 19. The method for forming a semiconductor package of clause 15, further comprising:
   dicing the molding compound and the stress buffer structure at an interface between the molding compound and the stress buffer layer of the stress buffer structure along a direction that is substantially perpendicular the interface between the molding compound and the stress buffer layer of the stress buffer structure.
Clause 20. The method for forming a semiconductor package of clause 19, wherein forming the conductive bump structure further comprises:
   forming an under bump metallurgy (UBM) layer on the conductive stud and opposite the RDL structure; and
   forming a conductive ball structure on the under bump metallurgy (UBM) layer.

## Claims

1. A semiconductor package (500A, 500B), comprising:
a redistribution layer, RDL, structure (316-2, 316B) having a first surface (316TS) and a second surface (316BS) opposite to the first surface;
a first die (302, 304) disposed on the first surface of the RDL structure;
a stress buffer structure (316-1A, 316-1B) disposed on the second surface of the RDL structure, wherein the stress buffer structure comprises a stress buffer layer (314, 414) and a conductive stud (312) passing through the stress buffer layer; and
a conductive bump structure (322) disposed on the conductive stud and opposite to the first die, wherein the conductive bump structure is electrically coupled to the first die by the stress buffer structure and the RDL structure.

2. The semiconductor package as claimed in claim 1, wherein the RDL structure comprises a conductive via (318) having a size smaller than the conductive stud.

3. The semiconductor package as claimed in claim 1 or claim 2, wherein sidewalls of the stress buffer structure protrude beyond the corresponding sidewalls of the RDL structure, and wherein the RDL structure partially covers the stress buffer structure.

4. The semiconductor package as claimed in any one of claims 1 to 3, wherein a coefficient of thermal expansion (CTE) of the stress buffer layer is between 3.5 and 24 ppm/°C.

5. The semiconductor package as claimed in any one of claims 1 to 4, further comprising:
a molding compound (330) disposed on the RDL structure and surrounding the first die, wherein the molding compound surrounds the RDL structure and is in contact with the stress buffer layer.

6. The semiconductor package as claimed in claim 5, wherein sidewalls (330E) of the molding compound are level with corresponding sidewalls (E1A, E1B) of the stress buffer structure.

7. The semiconductor package as claimed in claim 5 or claim 6, wherein an interface (F1) between the stress buffer layer and the RDL structure is level with an interface (F2) between the stress buffer layer and the molding compound.

8. The semiconductor package as claimed in any one of claims 5 to 7, wherein the RDL structure and the molding compound together cover the entire top surface (314T, 414T) of the stress buffer structure; and/or
wherein the RDL structure is in contact with the stress buffer structure, and the molding compound is in contact with the stress buffer structure.

9. The semiconductor package as claimed in claim 1, further comprising:
a passivation layer (310) disposed on the stress buffer layer and surrounding a portion of the conductive stud, wherein the conductive stud is in contact with the conductive bump structure (322) by passing though the passivation layer.

10. The semiconductor package as claimed in claim 9, wherein a surface (316-1BS) of the passivation layer exposed from the stress buffer layer forms a bottom surface of the stress buffer structure; and/or
wherein the passivation layer surrounds a portion of the conductive stub close to a bottom surface of the stress buffer structure.

11. The semiconductor package as claimed in claim 1, wherein the thickness of the conductive stud is smaller than the thickness of the first die.

12. A method for forming a semiconductor package (500A, 500B), comprising:
forming a conductive stud (312) and a stress buffer layer (314, 414) surrounding the conductive stud on a carrier (360), wherein the conductive stud and the stress buffer layer form a stress buffer structure;
forming a redistribution layer, RDL, structure (316-2) on the stress buffer structure;
disposing a first die (302, 304) on the redistribution layer (RDL) structure; and
forming a conductive bump structure (322) on the conductive stud of the stress buffer structure and opposite to the first die.

13. The method for forming a semiconductor package (500A, 500B) as claimed in claim 12, wherein forming the conductive stud and the stress buffer layer surrounding the conductive stud on the carrier comprises:
forming a passivationlayer (308) and a seed layer (310) on the carrier in sequence, wherein the passivation layer has an opening (OP1);
forming the conductive stud on the seed layer;
forming a stress buffer layer (314) covering the passivation layer and the conductive stud; and
removing a portion of the stress buffer layer until the conductive stud is exposed; or
wherein forming the conductive stud and the stress buffer layer surrounding the conductive stud on the carrier comprises:
forming a seed layer (308) and a passivation layer (310) on the carrier in sequence, wherein the passivation layer has a first opening (OP1) exposing a portion of the seed layer;
forming a stress buffer layer (414) covering the passivation layer and the seed layer exposed from the first opening of the passivation layer;
forming a second opening (OP2) passing through the stress buffer layer, wherein the second opening is aligned with the first opening;
forming the conductive stud on the seed layer in the first opening of the passivation layer and the second opening of the stress buffer layer; and
removing a portion of the stress buffer layer and a portion of the conductive stud, so that surfaces (312T, 414T) of the stress buffer layer and conductive stud away from the carrier are flush with each other.

14. The method for forming a semiconductor package as claimed in claim 12 or claim 13, further comprising:
forming a molding compound (330) on the stress buffer structure, wherein the molding compound surrounds the RDL structure and the first die; and
removing the carrier from the stress buffer structure.

15. The method for forming a semiconductor package as claimed in any one of claims 12 to 14, further comprising:
dicing the molding compound and the stress buffer structure at an interface (F2) between the molding compound and the stress buffer layer of the stress buffer structure along a direction (D12) that is substantially perpendicular the interface between the molding compound and the stress buffer layer of the stress buffer structure;
wherein forming the conductive bump structure further comprises:
forming an under bump metallurgy, UBM, layer (323) on the conductive stud and opposite the RDL structure; and
forming a conductive ball structure (324) on the under bump metallurgy (UBM) layer.
